# EUROPEAN PATENT SPECIFICATION

(11) **EP 1 521 302 B1**
(45) Date of publication and mention of the grant of the patent: **13.04.2011**
(21) Application number: 04447219.9
(22) Date of filing: 30.09.2004
(51) Int. Cl.: H01L 21/768

(54) **Method for formation of airgaps around an interconnect**
Herstellung von Luftspalten um eine Verbindungsleitung herum
Méthode de formation de vides remplis d'air autour une interconnexion

(30) Priority: 30.09.2003 US 507613 P
(43) Date of publication of application: 06.04.2005
(73) Proprietor: IMEC, 3001 Leuven (BE)
(72) Inventor: Beyer Gerald, 3001 Leuven (Belgium) (BE); Gueneau de Mussy, Jean-Paul, 1050 Elsene (Belgium) (BE); Maex Karen, 3020 Herent (Belgium) (BE); Sutcliffe Victor, 3000 Leuven (Belgium) (BE)
(74) Representative: Van Malderen, Joëlle

(56) References cited:
- US-A1- 2002 055 243
- US-B1- 6 342 722
- US-B1- 6 492 245

## Description

### FIELD OF THE INVENTION

The present invention is related to the field of semiconductor processing.

More specifically it is related to the production of micro and nano-electromechanical systems (MEMS, NEMS) and to the production of low dielectric isolation for interconnects. It contributes to the exploration of the field of airgaps integration in semiconductor devices.

### Background of the invention

The use of airgaps in semiconductor devices is known. Airgaps in the form of cavities can typically be present in MEMS and NEMS devices. Those airgaps can structurally be part of such a device or can have a functional role.

Airgaps are considered to be very promising in the technology of interconnects, where they can be used as dielectric for isolation of interconnects. As IC technology scales down, the interconnect is becoming the most important restricting factor in terms of propagation delay, dynamic power consumption and signal errors originated by cross-talk effects between adjacent metal lines. The refocus from aluminium to copper has given an important reduction in the resistance of wired connections on the chip. At the moment, the aim is to achieve better isolation between the lines by introducing materials with lower dielectric constant than that of silicon oxide (k=4.2) leading to reducing the capacitance (C). The integration of low-k materials (k<3.0) into production processes creates a number of challenges associated with leakage, mechanical instability and joule heating, increasing the overall cost of future IC processes. Additionally, the barrier and intermediate layers tend to increase the effective permittivity of the final stack. Due to the aforementioned problems, and also because air is the best insulator available, a strong incentive exists to integrating airgaps between adjacent metal lines.

The use of air as a dielectric to isolate electrical interconnects is known to reduce RC delay as well as dynamic power consumption and signal errors (e.g. cross-talk).

Different ways of inducing air cavities are known in the art, for instance:
(i) Isotropic Etching (for MEMS applications): consist of using HF for dissolving a sacrificial SiO₂ layer, where other non reacting film (i.e. SiC) is employed as an etch stop. The etch source is then sealed by a non conformal CVD SiO₂ layer.
(ii) Anisotropic Etching: this consists of eliminating material by anisotropic dry etch, it is then necessary having a dedicated mask and adding the subsequent dry etch and strip operations. Subsequently a conformal CVD SiO₂ followed by a non conformal CVD SiO₂ film is deposited on top of the lines responsible for the creation of airgaps.

In US 6,268,261 a process for manufacturing a semiconductor circuit comprising airgaps is disclosed. The process comprises creating a plurality of adjacent conductive lines having a solid fill between the conductive lines; creating one or more layers above the lines and the fill; creating one or more pathways to the fill through the layers; and converting the fill to a gas that escapes through the pathways, leaving an air void between adjacent lines. The process results in a multi-layer semiconductor circuit comprising conductive lines, wherein the lines have air as a dielectric between them. Here a solid fill needs to be deposited inside between the conductive lines. This fill has to be stable during deposition of the layers on top. In the layers on top a pathway needs to be foreseen, which requires additional processing such as extra masking and etching steps.

In US patent 6,599,814 a method is disclosed for removal of silicon carbide layers and in particular amorphous SiC of a substrate. Initially, the exposed part of a carbide-silicon layer is at least partly converted into an oxide-silicon layer by exposing the carbide-silicon layer to an oxygen containing plasma. The oxide-silicon layer is then removed from the substrate.

### Summary of the invention

The present invention provides a method for making airgaps in a stack of layers of a semiconductor device, said stack of layers comprising:
- a first dielectric material, which is resistant to a first etching composition,
- a second dielectric material upon said first dielectric material,
wherein said method comprises the steps of:
- etching with a second etching composition at least one hole in said stack of layers,
- converting chemically and/or mechanically the sidewalls of said hole(s) in said first dielectric material into a dielectric material that is etchable by said first etching composition,
- depositing in said hole(s) an electrically conductive material,
- removing the second dielectric material and any overburden of said conductive material for exposing the converted dielectric material,
- contacting said first etching composition with said converted dielectric material for removing the latter.

Said stack of layers may further comprise a hardmask (e.g. metal hardmask) on top of said second dielectric material.

Said hardmask may replace said dielectric material, according to another method of the invention.

In a method according to the invention, said first etching composition may comprise hydrofluoric acid (HF).

Said first etching composition can comprise less than (about) 5 wt.% HF, preferably less than (about) 2 wt.% HF and more preferably (about) 1 wt.% HF.

In a method according to the invention, said etching of at least one hole can be performed by an oxidizing plasma, wherein said plasma may comprise oxygen or N₂/H₂, and may further comprise an (hydro)fluorocarbon compound.

In a method according to the invention, the step of etching at least one hole and the conversion step can be performed simultaneously.

The present invention also provides a method for making a semiconductor device comprising the steps of a method of the invention for making airgaps.

The present invention also provides a method step of forming a cap layer on said stack of layers, after said contacting step.

### Short description of the drawings

All figures/drawings are intended to illustrate some aspects and embodiments of the present invention. Devices are depicted in a simplified way for reason of clarity. Not all alternatives and options are shown and therefore the invention is not limited to the content of the given drawings. Like numerals are employed to reference like parts in the different figures.

Fig. 1 to Fig. 6 illustrate different processing steps of the method according to the present invention. Figures 3a, 4a, 5a and 6a show partial airgap formation adjacent to Cu lines. Figures 3b, 4b, 5b and 6b show complete removal of all the intermediate dielectric material between two adjacent Cu lines leaving only an airgap between the adjacent Cu lines. Complete removal of the dielectric material is possible in case two adjacent Cu lines are close to each other (e.g. 50 nm)

Figure 7 shows an additional process flow to illustrate the practical examples.

Figure 8 shows the average RC delay versus pitch size for wafers with and without airgaps. The bars represent the RC delay drop for each pitch.

Figure 9 shows average capacitance data for wafers with and without airgaps. The bars represent the respective drop for each pitch.

Figure 10 shows cross-sectional SEM images of Cu/Low-k/Airgaps/Passivation structures with interline spacing of L/S = (a) 150/150 nm, (b) 200/200 nm and (c) 250/250 nm.

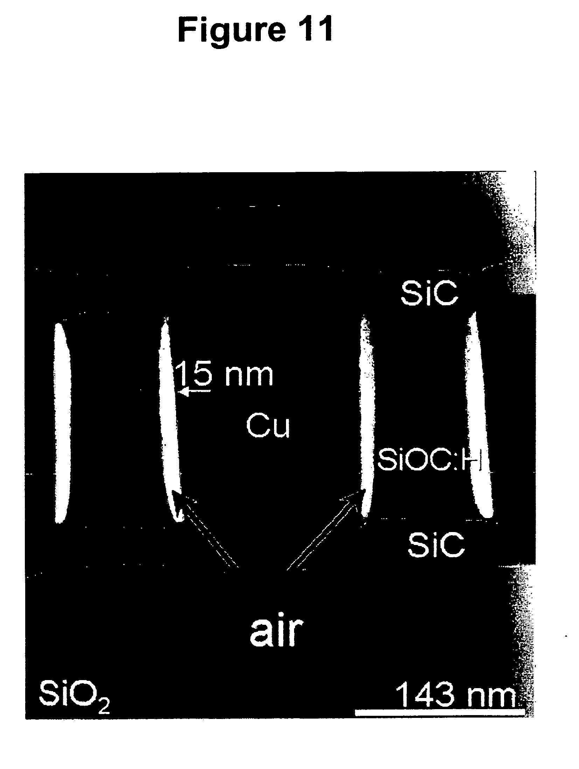

Figure 11 shows cross-sectional TEM images of Cu/Low-k/Airgaps/Passivation structures showing airgaps with dimension of 15 nm with a SiC capping layer (passivation). The width of the airgap typically corresponds to the thickness of the SiOx film after oxidation of SiCO:H, which can be tuned during the RIE (etch) process used to etch the holes in the dielectric material.

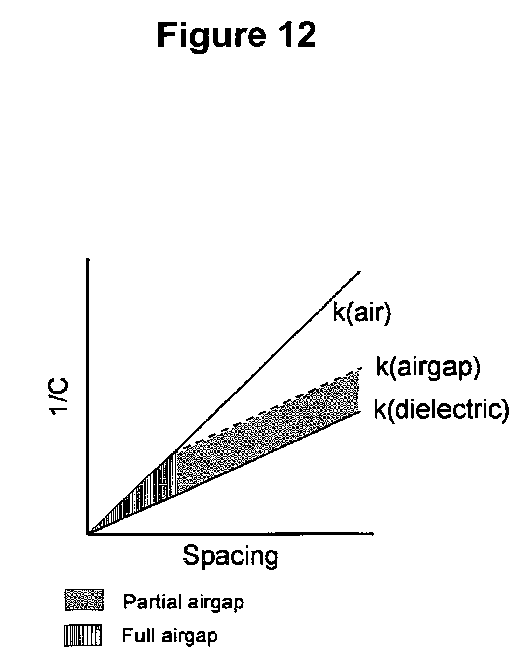

Figure 12 shows the k-value of low-k material with partial airgaps adjacent to Cu lines and full airgap formation in between Cu lines compared to the k-value of air.

Figure 13 shows a Dual Damascene (DD) interconnect structure. Airgaps (7) can be formed in the dielectric material (1) near the vias as shown in Figure 13(c), near the trenches as shown in Figure 13(b) or both near vias and trenches as shown in Figure 13(a)). Most preferred is the formation of airgaps near the trenches and leave original dielectric material (1) near the via structure. Leaving the original dielectric material (1) near the via structures will give more mechanical support to the Dual Damascene structure.

### Detailed description of the drawings

The present invention provides a method for the production of isolated lines or interconnects in a semiconductor device, said semiconductor device comprising a stack of layers, said stack of layers comprising at least a first dielectric layer made of a first dielectric material and a second dielectric layer made of a second dielectric material. Said second dielectric layer is situated on top of said first dielectric material. Said first dielectric layer and (optionally) said second dielectric layer are resistant to a first etching substance.

The formation of airgaps is based on chemically and/or mechanically changing the properties of a first dielectric layer locally, such that the hole part(s) of said first dielectric layer is converted locally and becomes etchable by a first etching substance.

The conversion (oxidation) of said material can be achieved during anisotropic etching of said material in an oxygen containing plasma or ex-situ by intruding an oxidizing step e.g. UV/ozone treatment or supercritical carbondioxide with addition of an oxidizer.

Formation of airgaps is achieved after creation of conductive lines (with optionally a barrier layer) by a first etching substance, said etching substance being preferably an HF containing ambient.

A method according to claim 1 is for the production of airgaps in a stack of layers of a semiconductor device, said stack of layers comprising:
- a first dielectric layer made of a first dielectric material;
- a second dielectric layer made of a second dielectric material on top of said first dielectric material;
wherein said first dielectric materiel is resistant to a first etching composition;
said method comprising the steps of:
- etching with a second etching composition at least 1 hole in said stack of layers,
- chemically and/or mechanically converting the sidewalls of said hole(s) in said first dielectric material into a dielectric material that is etchable by said first etching composition,
- depositing in said hole (s) an electrically conductive material, optionally after depositing a barrier layer,
- removing the second dielectric material and any overburden of said conductive material for exposing the converted dielectric material,
- contacting said first etching composition with said converted dielectric material for removing the latter.
-

Further, a method is provided for making airgaps in a stack of layers of a semiconductor device, said stack of layers comprising:
- a first dielectric material, which is resistant to a first etching composition,
- a hardmask or a metal hardmask upon said first dielectric material,
wherein said method comprises the steps of:
- etching with a second etching composition at least one hole in said stack of layers,
- converting chemically and/or mechanically the sidewalls of said hole(s) in said first dielectric material into a dielectric material that is etchable by said first etching composition,
- depositing in said hole (s) an electrically conductive material,
- removing the hardmask or the metal hardmask and any overburden of said conductive material for exposing the converted dielectric material,
- contacting said first etching composition with said converted dielectric material for removing the latter.

Preferably the first dielectric material is a (hydrogenated) silicon oxycarbide (SiCO:H) material.

The first dielectric material is preferably more porous than the second dielectric material.

The method comprises the steps of etching at least 1 hole in said stack of layers and chemically and/or mechanically converting the sidewalls of said hole(s) in said first dielectric material into a material that is etchable by said first etching composition.

The conversion in the first dielectric layer comprises a loss of carbon out of said material such that at least a partly carbon depleted or completely carbon depleted dielectric material is created at least locally in said first dielectric layer.

Preferably the etching of the hole in said first dielectric layer is anisotropic and the etch plasma is an oxidizing plasma.

Preferably the oxidizing plasma is an oxygen containing plasma or a N₂/H₂ containing plasma.

The etch plasma can further comprise (hydro)fluorocarbon compounds.

Using an oxidizing plasma, the conversion of the first dielectric material can be simultaneous with the etching of the hole in said first dielectric material.

The conversion of the first dielectric can be performed after the etching of the hole(s) in said first dielectric material in an oxidizing environment. The conversion step then comprises an UV/ozone treatment with addition of an oxidizer or a SCCO₂ treatment with addition of an oxidizer.

The conversion of the first dielectric material can also be made in an inert gas plasma by ion bombardment. This treatment also leads to carbon depletion in said first dielectric material. This conversion can be understood as a mechanical conversion because no chemical reaction such as oxidation is involved herewith.

Said converted dielectric material has in-plane dimensions smaller than 1 µm, preferably smaller than 500 nm and more preferably smaller than 100 nm.

After depositing in said hole(s) a layer of electrically conductive material and optionally also a barrier layer, a subtractive technique is applied on said stack of layers hereby exposing the converted dielectric material at the surface of said stack of layers and creating at least 1 line of conductive material.

Said stack of layers is then subjected to a first etching substance whereby airgaps are created around said line(s). Preferably this first etching substance contains HF and more preferred the etching is performed by dipping the structures in an aqueous solution comprising HF.

Preferably, said aqueous HF solution contains less than about 5 wt.% HF, preferably less than about 2 wt.% HF and more preferably about 1 wt.% HF.

The disclosed method for the production of airgaps in a semiconductor device wherein said stack of layers comprises a first dielectric layer made of a first dielectric material and a second dielectric material can further comprise a hardmask or metal hardmask on top of said stack of layers.

Examples of hardmask layers are SiO₂, SiC, SiN and SiC(N).

SiOC, MSQ and HSQ materials can also be used as hardmask layers but these materials must have densities higher than the dielectric layer under said hardmask layer in said stack of layers.

Examples of metal hardmask layers are TaN, TiN, WCN, WN etc.

Optionally there is no second dielectric layer in said stack of layers and the hardmask or metal hardmask is situated on top of the first dielectric layer.

The conductive lines formed in the holes in said stack of layers can be horizontal lines (also referred to as "trenches") or vertical structures (also referred to as "vias").

The via and trenches are preferably part of a (dual) damascene structure in the back end of line (BEOL) of a semiconductor device.

In a preferred embodiment, the airgap is created in a (Dual) Damascene structure.

More preferably, the airgap is situated near the via or trenches of said structure and even more preferably the airgap is situated near the trenches.

In a preferred embodiment, the first dielectric material is completely removed between 2 neighbouring conductive lines.

Preferably the conductive material is selected from the group consisting of metals, carbon nanotubes, conducting polymers. The conductive material can be for example Cu, Au or Ag.

More specifically a method for the production of airgaps in a semiconductor device is disclosed and illustrated by the figures.

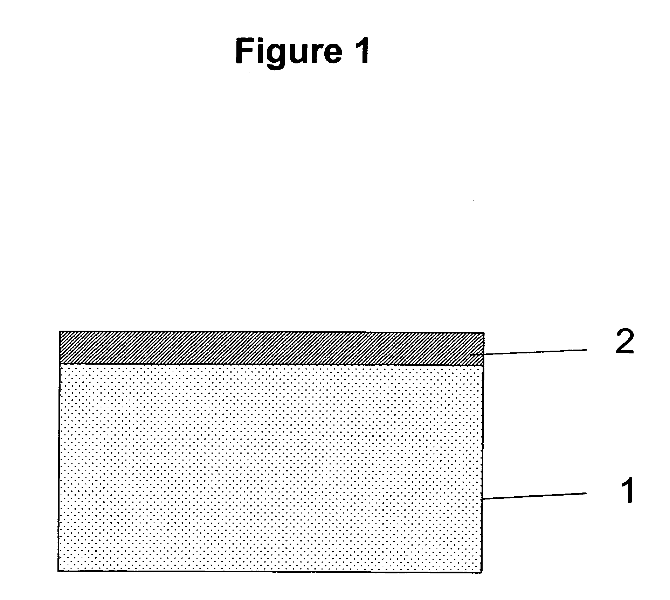

As shown in Fig. 1 first a dielectric material (1) is deposited on a Si substrate or any other suitable substrate (which is not shown in the Figures) by a method such as for instance Plasma Enhanced Chemical Vapour Deposition (PECVD), Chemical Vapour Deposition (CVD), spin-on deposition etc. On top of dielectric material (1) another dielectric material (2) is deposited by for instance any method that has been described for material (1).

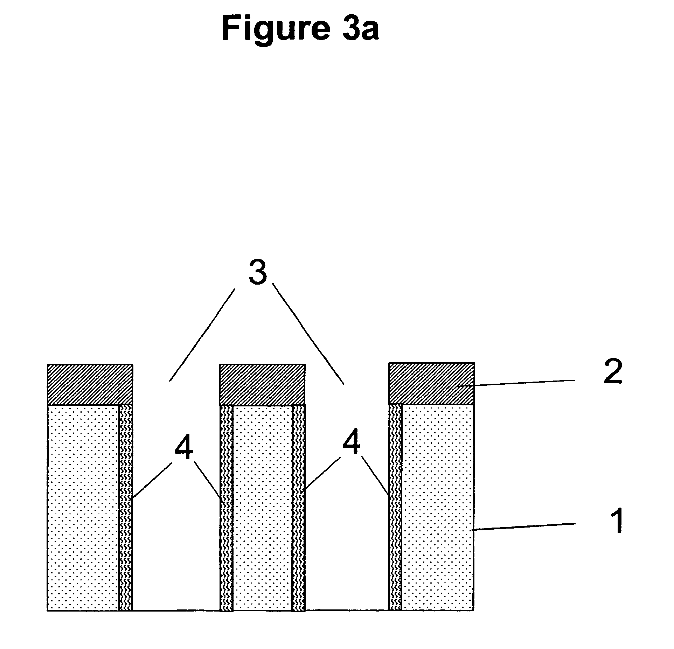

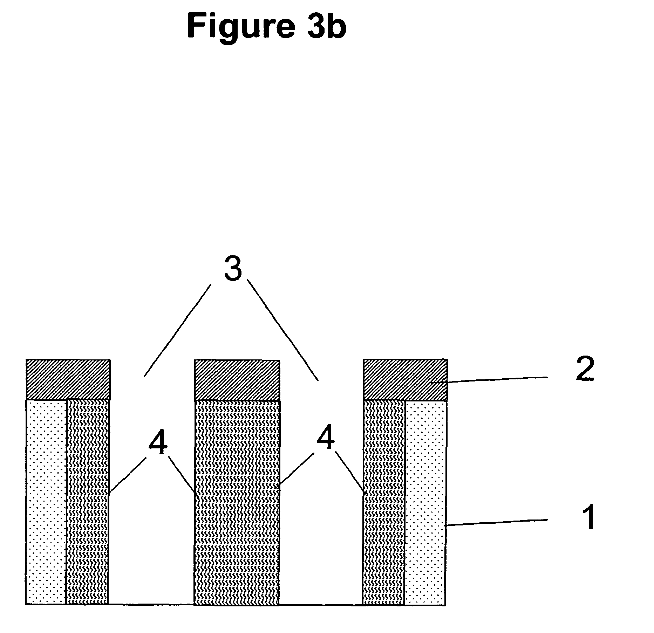

A function of dielectric material (2) is to protect the field region of dielectric (1) from plasma conversion, which is further discussed (see Fig. 3a and b).

Examples of material (1) are the Organo Silicate Glass (OSG), which are also commonly referred to as SiOC:H materials, (hydrogenated) silicon oxycarbides or Carbon doped oxides (including higher porosity derivatives). The class of MethylSilsesQuioxane (MSQ) is another example of material (1). Said materials (1) are characterized by a Si backbone which is carbon doped. Examples of these are commercially available materials such as Black Diamond (referred to as BD), Coral or Aurora.

Preferred examples of material (2) are SiO₂ or SiC or SiCN.

Material (1) and material (2) can be the same type of material but in this case they need to have different porosity. In case both material (1) and (2) are SiCO:H like materials, material (2) needs to be characterized by a lower porosity such that less plasma conversion will take place and the material (2) can still protect the field region of material (1) (i.e. dielectric material between the conductive material lines). A lower porosity SiCO:H material will be less susceptible to conversion of the material due to an O₂ containing plasma. A higher porosity SiCO:H material contains more carbon and more carbon will be removed in an O₂ containing plasma.

(Metal) hardmasks can also be used as alternative material for dielectric material (2) or used on top of dielectric material (2) to act as hardmask for the anisotropic etching.

Metal hardmasks are hardmasks containing metals. Examples of these metal hardmasks are TaN, TiN, etc.

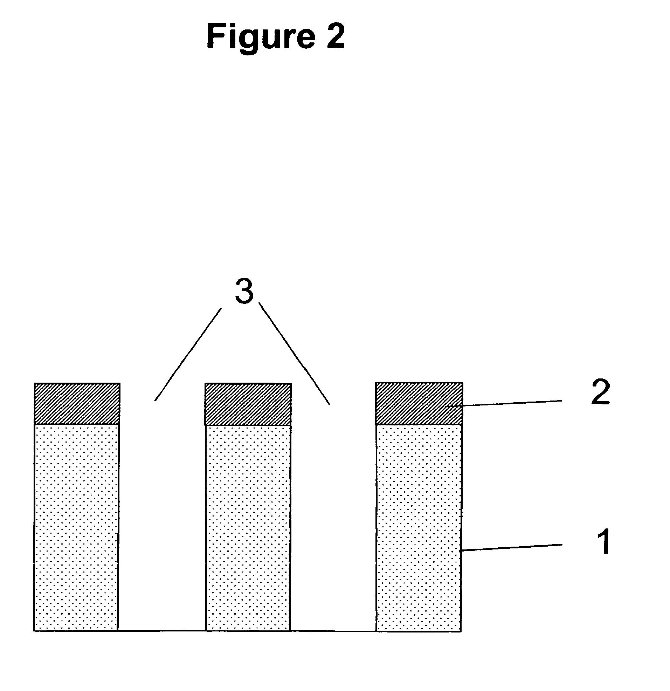

As illustrated in Fig. 2, a hole (3) is etched into the dielectric stack by transferring a resist pattern (not shown here) into the dielectric stack using an etch plasma. The remaining resist and polymers (not shown here) are then removed by a combination of dry ash plasma and wet strip. The (metal) hardmask and/or the dielectric material (2) protects the field region of dielectric (1), such that no conversion of the dielectric (1) at the field takes place.

The etch plasma and/or ash plasma may cause some local conversion of dielectric (1) into a modified dielectric (4) (Fig. 3 a and b), which is removed faster in a latter stage of processing by an etch medium than dielectric (1). The conversion of dielectric (1) into (4) is, however, no prerequisite at this step.

The conversion of dielectric material towards converted dielectric material (4) is done by oxidation of the SiCO:H material. Oxidation leads to the removal of carbon out of the material (probably as carbon dioxide).

A plasma treatment, which is not necessarily identical to the plasma used to etch a hole in the dielectric material, or alternative treatment such as for example UV-ozone, super critical carbon dioxide (SCCO₂) or a combination of aforementioned treatments converts the sidewalls of dielectric (1) in the hole into dielectric (4) (Fig. 3a and b). The treatment leads to a reduced carbon concentration in converted dielectric (4) as compared to dielectric (1).

The dielectric materials (4) are carbon depleted SiCO:H materials. The extent of the conversion of dielectric material (1) into dielectric material (4) is depending on the type of SiCO:H material (1), more specifically on the porosity and carbon content of dielectric material (1). In case of complete carbon removal out of the SiCO:H material, they are also referred to as SiOx material. A SiOx film corresponds to a Si (silicon) and O (oxygen) containing film, where both elements are not stoichiometrically related. This sort of film has typically more defects and is less cross-linked as compared to a SiO₂ one. Because the SiOx material is less cross-linked it is more susceptible to HF etching (removal process).

The conversion of the dielectric material (1) into converted dielectric material (4) can be performed in-situ (simultaneously) during the dry etching of the dielectric material (1) and/or ashing using an oxidizing plasma.

The conversion of the dielectric material (1) into converted dielectric material (4) can be performed in-situ, during the dry etching process to create a hole in dielectric material (1).

The conversion of the dielectric material (1) into converted dielectric material (4) can be also ex-situ by performing an additional (oxidizing) treatment to the dielectric material (1) after the dry etching of the dielectric material (1) such as UV-ozone treatment, Super Critical CO₂ (SCCO₂) with addition of an oxidizer. Several other oxidizing treatments are applicable to oxidize the dielectric material (1).

The lateral extent of the conversion of dielectric material (1) is controlled by the plasma or alternative conversion process and the porosity of the SiOC:H material. A complete (3b) or partial conversion (3a) of the dielectric (1) between two or more neighbouring trenches is possible.

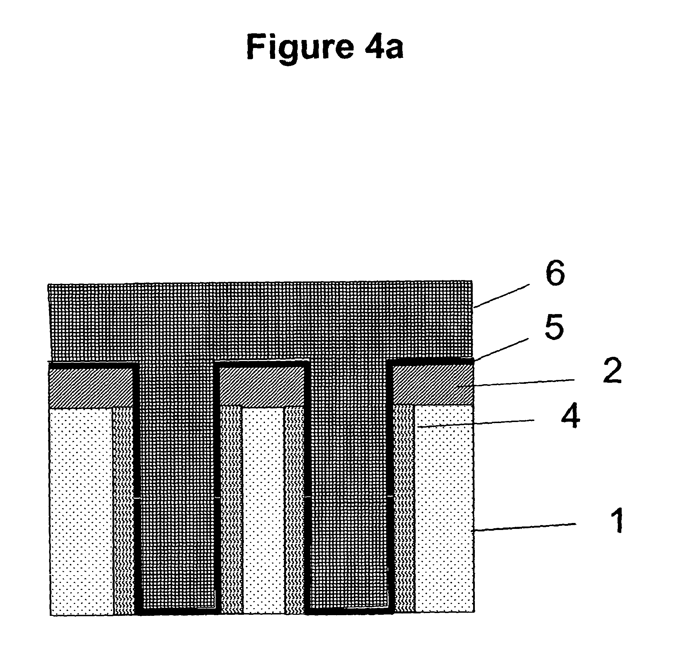

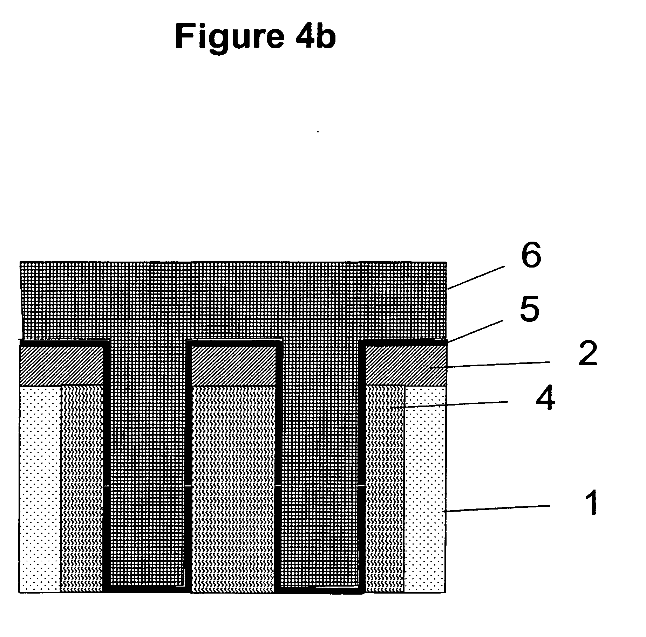

The sidewalls of the hole and the field are then lined with a barrier layer (5) (Figure 4 a and b), which may be deposited by Physical Vapour Deposition (PVD), Chemical Vapour Deposition (CVD), Metal Organic Chemical Vapour Deposition (MOCVD), Atomic Layer Deposition (ALD) and related methods. Typical examples of barrier layers are TaN, Ta, TiN, Ti, WN, WCN etc. This barrier layer can act as diffusion barrier.

The hole is then filled with a conductive material, for example Cu (6). Other possibilities are for instance any metals, carbon nanotubes, conductive polymers.

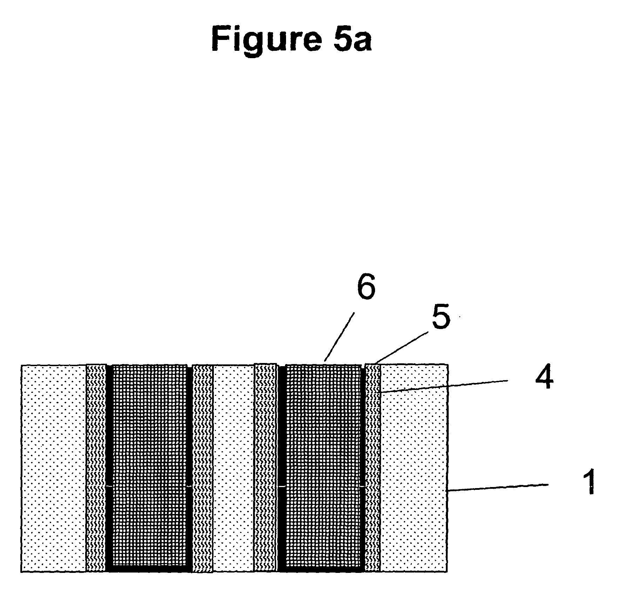

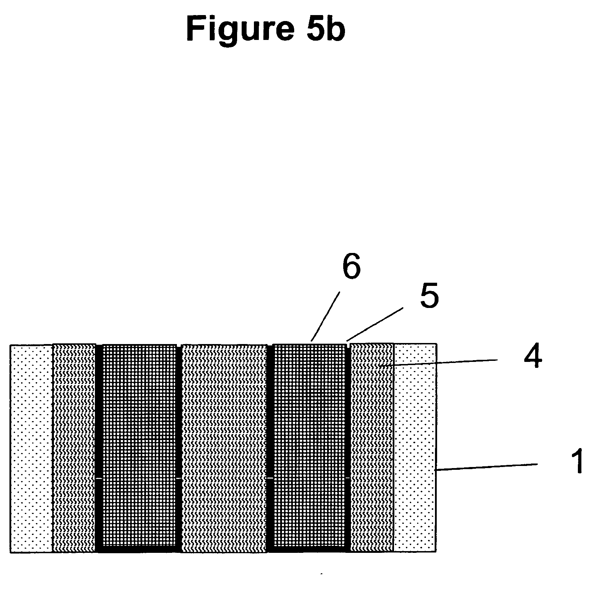

The overburden of the conductive material, for example the overburden of Cu, and the overburden of the barrier on the field are removed by a subtractive technique (Fig. 5a and b), which only leaves the barrier (5) and the Cu (6) in the hole in place.

Examples of the subtractive technique are Chemical Mechanical Polishing (CMP), Electro Polishing, etch or any combination of the mentioned techniques. The subtractive techniques also removes the dielectric (2) as shown in Fig. 5.

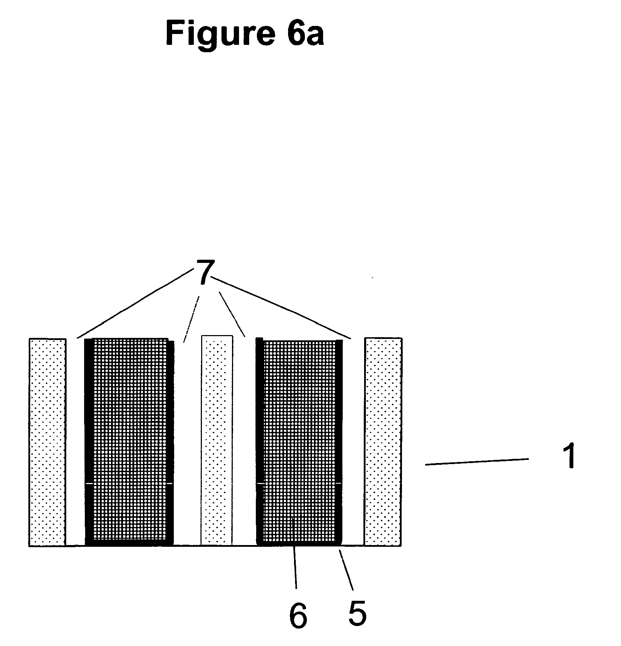

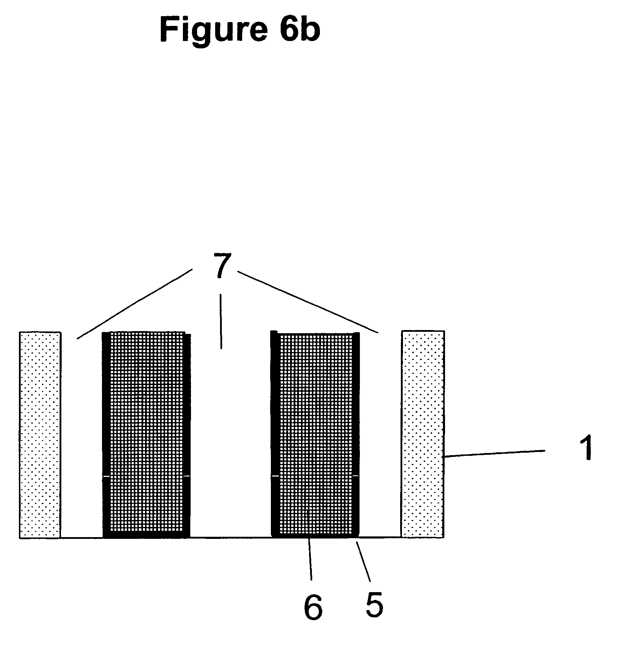

Converted dielectric material (4) can then be removed by an etch medium more quickly than the non-converted dielectric (1) as described in Figure 6a and b. The removal of the converted dielectric material is done by an HF (Hydrofluoric acid) treatment. Said HF treatment can be executed by subjecting the dielectric material (4) to an HF vapour or by dipping in a liquid HF solution (various HF concentrations with/without additives such as methanol) or subjecting to a Super Critical CO₂ (SCCO₂) environment with addition of HF, etc.

Complete removal of the dielectric material (4) will take place in smaller interconnect geometries (smaller interline spacing) such that the airgap spans the complete width between 2 neighbouring lines (Figure 6b).

The duration of the step of "chemically and/or mechanically converting the sidewalls of said hole(s) in said first dielectric material" is more critical, when compared to the duration of the step "contacting the first etching composition". The step of "chemically and/or mechanically converting the sidewalls of said hole(s) in said first dielectric material" will determine which area will be etched by the etching step of "contacting the first etching composition".

The distance between neighbouring conductor lines is determined by the limitations of standard techniques with respect to forming neighbouring holes in the stack of layers. Typically metal lines are spaced at about 100 nm. The present invention is a scaling invariant and is not limited to any distance between conductor lines, since the step of "chemically and/or mechanically converting..."
can be applied on nanometer scale and smaller.

If the distance between neighbouring conductor lines is smaller then 100 nm it can be preferred to remove all the intermediate dielectric material and leave only an airgap in between. This is shown in Figures 3b, 4b, 5b and 6b.

For distances bigger than 100 nm it can be preferred to leave some dielectric material present between the lines. The presence of this dielectric can give mechanical support for the deposition of further layers on the airgap structure created by the present invention.

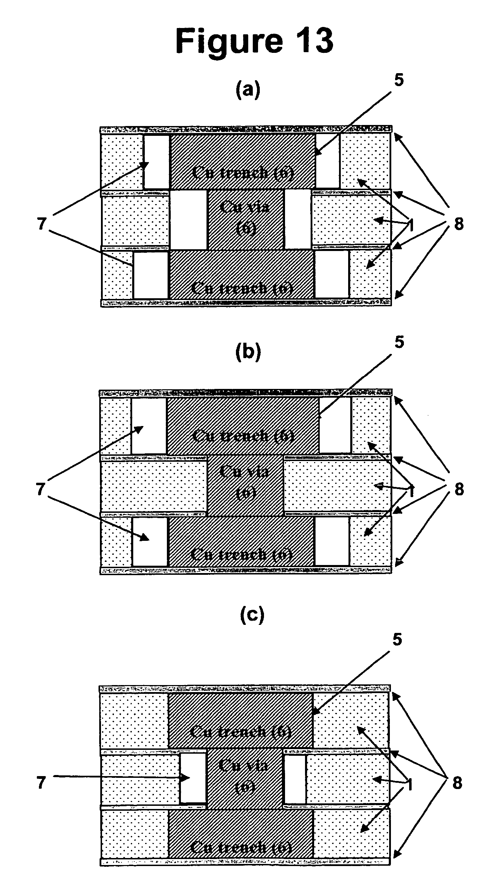

In preferred embodiments the method according to the present invention can be repeated; on top of an airgap structure new layers can be formed, on which the method according to the present invention can be repeated. In a Dual Damascene (DD) interconnect structure as illustrated in Figure 13, airgaps (7) can be formed in the dielectric material near the vias (as shown in Figure 13 (c)), near the trenches (as shown in Figure 13(b)) or both (as shown in Figure 13(a)). Most preferred is the formation of airgaps near the trenches and leave original dielectric material (1) near the via structure. Leaving the original dielectric material (1) near the via structures will give more mechanical support to the Dual Damascene structure.

The invention is described in further details in the following examples, which are intended for illustration purposes only, and should not be construed as limiting the scope of the invention in any way.

### Practical examples:

### Example 1: Brief description of a process flow to create airgaps

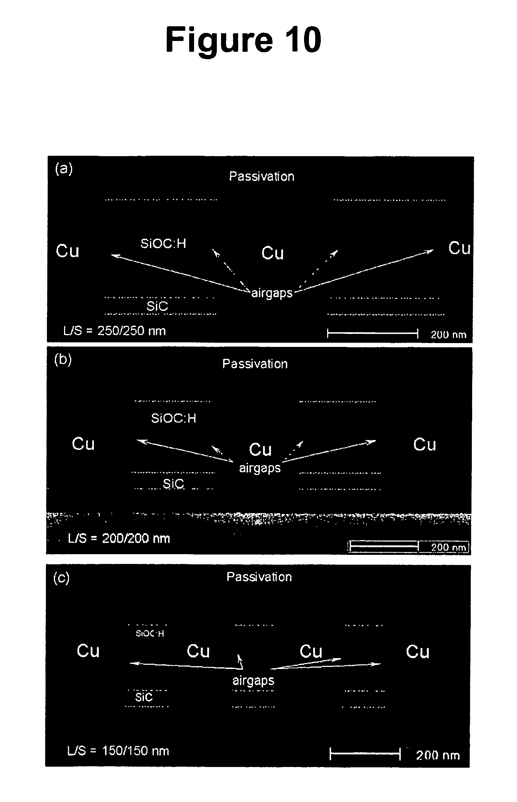

The structure as depictured in Figure 10 was created by depositing Ultra Low-k dielectric (ULK) material as dielectric (1), and SiO₂ as dielectric (2) using standard process steps. Resist patterns were created in standard resist and standard 193 nm optical lithography. In order to create a hole, the resist pattern is transferred into the dielectric stack using a standard plasma etch system. The plasma contained argon, oxygen, and fluorocarbon molecules. The resist is ashed by a plasma in a standard ash system using oxygen and fluorocarbon molecules. A TaN/Ta barrier (5) and copper (6) were deposited in the hole and on the field and subsequently removed on the field by standard systems. The converted dielectric was then removed by diluted hydrofluoric acid leading to the creation of airgaps (7) adjacent to the wires.

### Example 2: Detailed process-flow for airgap formation

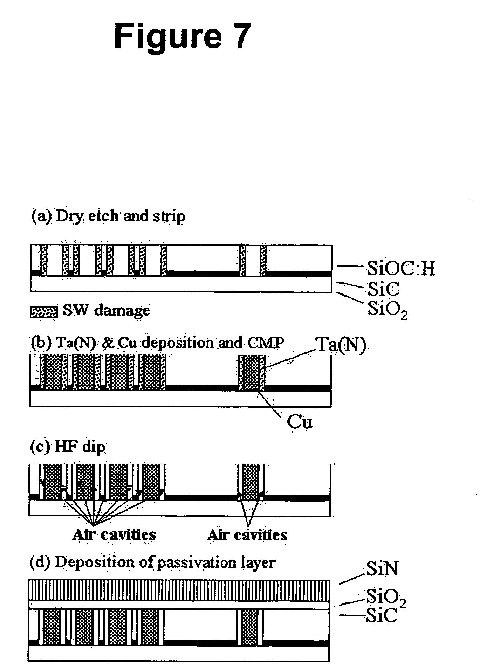

The overall process is shown in Figure 7. In first place, the stack composed of a 50/200/50/275/13 nm Si3N4/SiO₂/SiC/SiOC:H/SiO₂ was formed on a Si (100) wafer by plasma enhanced chemical vapor deposition (PE-CVD). Patterning was achieved by 193 nm wavelength optical lithography. Dry etch and resist ash were carried out in a Lam Exelan2300TM chamber using a CF₄/CH₂F₂/Ar/O₂ plasma at low pressure and an O₂/CF₄ plasma at high pressure respectively. Both dry etch and resist ash processes were carefully controlled in order to induce a defective SiOx film at the sidewalls of SiOC:H trenches (Figure 7(a)). Then a 15/10 nm Ta/Ta(N) diffusion layer and a 100 nm Cu seed layer were formed by ionized physical vapor deposition (i-PVD). Trenches were filled by copper electroplating and the exceeding metal was removed by chemical mechanical polishing (CMP) as shown in Figure 7(b). HF selectively dissolves SiOx vs. SiOC:H leading to airgap formation at sidewalls as depicted in Figure 7(c). The HF dip time was controlled such that the SiOx layer was removed with minimum attack of the SiCO:H layer, the Ta/Ta(N) diffusion barrier and the Cu conductor. Subsequently a 50/330/500 nm SiC/SiO₂/Si₃N₄ passivation layer was deposited on top as shown in Figure 7(d).

### Example 3: Electrical Characterization

Processed samples with and without airgaps (with airgap formation as described in previous example) were devoted to a full electrical assessment at wafer level. Wafers D07, D09, D10, D11, D18, D19, D20, D21, D22 and D23 were processed with airgap formation. All samples consisted of structures with different interconnect geometries and thus different interline spacing. More specific the interline spacing between different structures on the wafer was either 0.15 µm, 0.20 µm or 0.25 µm. A passivation layer was deposited on all structures of the wafers after processing except for wafer D10. Wafer D08 did not have airgap formation and acted as a reference sample. The main characteristics of the different wafers are given in Table 1.

**Table 1. Characteristics of processed samples.**

| **Wafer** | **HF dip time (min)** | **passivation** |
|---|---|---|
| D07 | 3.5 | yes |
| D08 | 0 | yes |
| D09 | 3.5 | yes |
| D10 | 3.5 | no |
| D11 | 3.5 | yes |
| D18 | 3.5 | yes |
| D19 | 3.5 | yes |
| D20 | 3.5 | yes |
| D21 | 3.5 | yes |
| D22 | 3.5 | yes |
| D23 | 3.5 | yes |

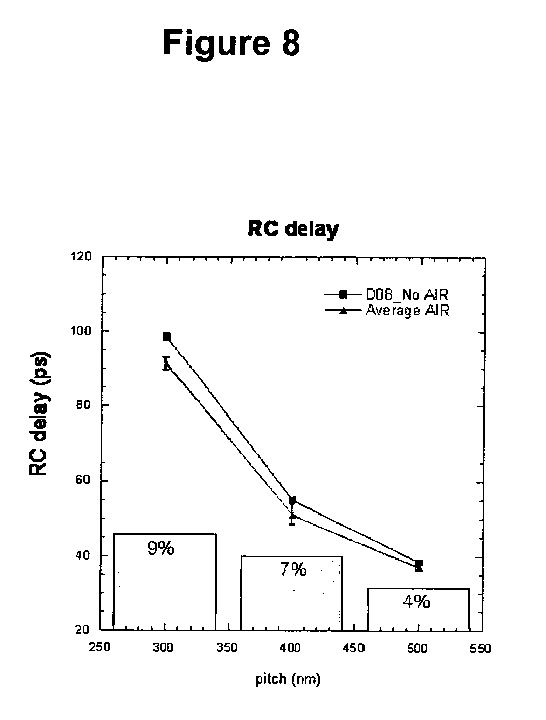

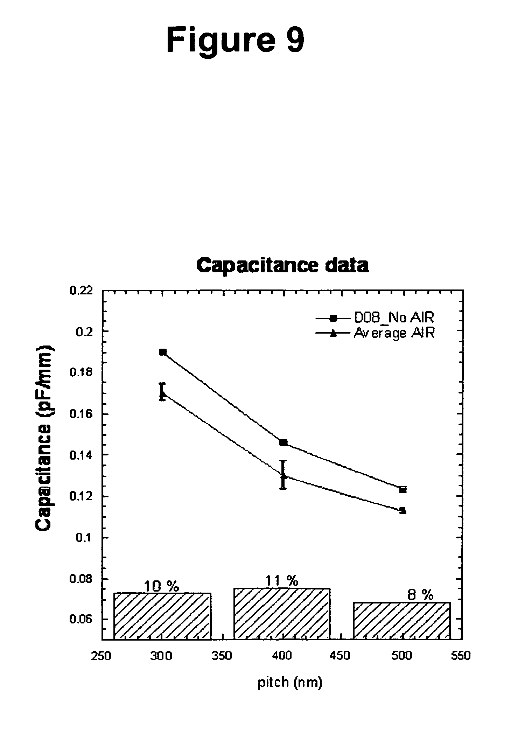

Table 2 displays RC-delay data for passivated samples with airgaps, while Table 3 shows RC-delay data for samples with and without airgaps. It is important to note that the RC-delay drop strongly depends on the interline spacing as shown in Figure 8. This is because the airgaps dimensions are constant for each pitch, inducing a more important capacitance drop for closer interconnects geometries as supported by Table 4 and Figure 9.

**Table 2. Average RC-delay for wafers with airgaps.**

| **RC-delay (ps)** | **D09** | **D11** | **D18** | **D19** | **D20** | **D21** | **D22** | **D23** |
|---|---|---|---|---|---|---|---|---|
| 0.15/0.15 µm, | 90.973 | 91.620 | 92.911 | 93.402 | 90.283 | 88. 809 | 92.044 | 90.562 |
| *0.15*/*0.15* µm, *std. dev.* | *0.730* | *0.583* | *2.909* | *2.487* | *2.058* | *1.319* | *2.488* | *1.651* |
| 0.20/0.20 µm, | 50.929 | 51.908 | 51.903 | 52.491 | 50.735 | 50.388 | 50.576 | 49.882 |
| *0.20*/*0.20* µm, *std. dev.* | *3.351* | *0.376* | *0.964* | *1.284* | *0.619* | *0.485* | *7.838* | *7.716* |
| 0.25/0.25 µm | 36.868 | 37.292 | 37.477 | 37.859 | 36.479 | 36.103 | 37.251 | 36.773 |
| *0.25*/*0.25* µm, *std. dev.* | *0.320* | *0.250* | *0.786* | *1.059* | *0.545* | *0.381* | *0.611* | *0.447* |

| | | | | | | | | |
|---|---|---|---|---|---|---|---|---|
| *(ps.: pico seconds ; std. dev.: standard deviation)* | | | | | | | | |

**Table 3. Average RC-delay for wafers with and without airgaps.**

| **RC-delay (ps)** | **NO AIR*** | **AIR**** | **drop** |
|---|---|---|---|
| 0.15/0.15 µm, | 100.517 | 91.326 | 9% |
| 0.20/0.20 µm, | 55.092 | 51.102 | 7% |
| 0.25/0.25 µm, | 38.417 | 37.013 | 4% |

| | | | |
|---|---|---|---|
| *: *Average of 44 dies data (1 wafer)* **: *Average of 352 dies data (8 wafers)* | | | |

**Table 4. Average Capacitance for wafers with and without airgaps.**

| **Capacitance (pF/mm)** | **NO AIR*** | **AIR**** | **drop** |
|---|---|---|---|
| 0.15/0.15 µm, | 0.190 | 0.170 | 10% |
| 0.20/0.20 µm, | 0.146 | 0.130 | 11% |
| 0.25/0.25 µm, | 0.123 | 0.113 | 8% |

| | | | |
|---|---|---|---|
| **Average of 44 dies data (1 wafer)* **: *Average of 352 dies data (8 wafers)* | | | |

### Example 4: SEM inspection of processed samples with airgaps

Figure 10 shows cross-sectional SEM images of Cu/SiOC:H/Airgaps/Passivation structures with interline spacing of L/S = 150/150 nm, 200/200 nm and 250/250 nm. After analyzing several images the airgaps dimensions are 25 to 35 nm thick and about 275 nm in height. These dimensions are similar to the ones of unpassivated airgaps structures meaning that the deposition of the passivation layer does not penetrate in the air cavities. The width of the airgap typically corresponds to the thickness of the SiOx film after oxidation of SiCO:H, which can be tuned during the RIE (etch) process used to etch the holes in the dielectric material.

## Claims

1. Method for making airgaps (7) in a stack of layers of a semiconductor device, said stack of layers comprising:
- a first dielectric material (1), which is resistant to a first etching composition,
- a second dielectric material (2) upon said first
dielectric material (1),
wherein said method comprises the steps of:
- etching with a second etching composition at least one hole (3) in said stack of layers,
- converting chemically and/or mechanically the sidewalls of said hole(s) (3) in said first dielectric material (1) into a dielectric material (4) that is etchable by said first etching composition,
- depositing in said hole(s) an electrically conductive material (6),
- removing the second dielectric material (2) and any overburden of said conductive material (6) for exposing the converted dielectric material (4),
- contacting said first etching composition with said converted dielectric material (4) for removing the latter.

2. A method for making airgaps (7) according to claim 1 wherein said stack of layers further comprises a
hardmask such as a metal hardmask on top of said second dielectric material (2).

3. A method for making airgaps (7) in a stack of layers of a semiconductor device, said stack of layers comprising:
- a first dielectric material (1), which is resistant to a first etching composition,
- a hardmask such as a metal hardmask upon said first dielectric material (1),
wherein said method comprises the steps of:
- etching with a second etching composition at least one hole (3) in said stack of layers,
- converting chemically and/or mechanically the sidewalls of said hole(s) (3) in said first dielectric material (1) into a dielectric material (4) that is etchable by said first etching composition,
- depositing in said hole(s) an electrically conductive material (6),
- removing the hardmask and any overburden of said conductive material (6) for exposing the converted dielectric material (4),
- contacting said first etching composition with said converted dielectric material (4) for removing the latter.

4. A A method for making airgaps (7) according to any of claims 1 to 3 wherein said first etching composition comprises hydrofluoric acid (HF).

5. A method for making airgaps (7) according to any of claims 1 to 4 wherein said step of etching at least one hole (3) is performed by an oxidizing plasma.

6. A method for making airgaps (7) according to claim 5 wherein said oxidizing plasma comprises oxygen.

7. A method for making airgaps (7) according to any of claims 1 to 4 wherein said step of etching at least one hole (3) is performed by a N₂/H₂ comprising plasma.

8. A method for making airgaps (7) according to claim 5 to 7 wherein said plasma further comprises a (hydro)fluorocarbon compound.

9. A method for making airgaps (7) according to any of claims 1 to 8, wherein said first dielectric material (1) is a SiCO:H material.

10. A method for making airgaps (7) according to any of claims 1 to 9 wherein said first dielectric material (1) is more porous than said second dielectric material (2).

11. A method for making airgaps (7) according to any of claims 1 to 10, wherein said conductive material (6) is selected from the group consisting of metals, carbon nanotubes, and conducting polymers.

12. A method for making airgaps (7) according to claim 11 wherein said conductive material (6) is copper.

13. A method for making airgaps (7) according to any of claims 1 to 12 wherein the step of etching at least one hole (3) in said stack of layers and the conversion step are performed simultaneously.

14. A method for making airgaps (7) according to any of claims 1 to 12 wherein the conversion step is performed in an oxidizing environment.

15. A method for making airgaps (7) according to claim 14 wherein the conversion step comprises an UV/ozone treatment with addition of an oxidizer or a SCCO2 treatment with addition of an oxidizer.

16. A method for making airgaps (7) according to any of claims 1 to 15 wherein said dielectric material (4) has in-plane dimensions smaller than 1 µm, or smaller than 500 nm, or smaller than 100 nm, or smaller than 50 nm.

17. A method for making a semiconductor device having airgaps comprising a method according to any of claims 1 to 16.

18. A method for making a semiconductor device having airgaps according to claim 17 further comprising the step of depositing a barrier layer (5), after said converting step.

19. A method for making a semiconductor device having airgaps according to claim 17 or 18 further comprising the step of depositing a capping layer upon said stack of layers, after said contacting step.

20. A method for making a semiconductor device having airgaps according to claim 19 wherein said capping layer is a SiC layer.

## Patentansprüche

1. Verfahren zur Herstellung von Luftspälten (7) in einem Schichtstapel eines Halbleiterbauelements, wobei dieser Schichtstapel umfasst:
- ein erstes dielektrisches Material (1), das einer ersten Ätzzusammensetzung widersteht,
- ein zweites dielektrisches Material (2) auf diesem ersten dielektrischen Material (1),
wobei dieses Verfahren die folgenden Schritte umfasst
- ätzen mit einer zweiten Ätzzusammensetzung mindestens eines Lochs (3) in diesem Schichtstapel,
- chemische und/oder mechanische Umwandelung der Seitenwände des Lochs oder der Löcher (3) im ersten dielektrischen Material (1) in ein dielektrisches Material (4) das durch die erste Ätzzusammensetzung ätzbar ist,
- auftragen eines elektrisch leitenden Materials (6) im Loch oder in den Löchern ,
- entfernen des zweiten dielektrischen Materials (2) und jedes Überschusses des leitfähigen Materials (6) um das umgewandelte dielektrische Material (4) freizulegen,
- zusammenbringen von dem ersten Ätzzusammensetzung mit dem umgewandelten dielektrischen Material (4) um Letzteres zu entfernen.

2. Verfahren zur Herstellung von Luftspälten (7) nach Anspruch 1, wobei dieser Schichtstapel außerdem eine Hartmaske wie z.B. eine Metallhartmaske auf dem zweiten dielektrischen Material (2) umfasst.

3. Verfahren zur Herstellung von Luftspälten (7) in einem Schichtstapel eines Halbleiterbauelements, wobei dieser Schichtstapel umfasst:
- ein erstes dielektrisches Material (1), das einer ersten Ätzzusammensetzung widersteht,
- eine Hartmaske wie z.B. eine Metallhartmaske auf dem ersten dielektrischen Material (1),
wobei dieses Verfahren die folgenden Schritte umfasst
- ätzen mit einer zweiten Ätzzusammensetzung mindestens eines Lochs (3) in diesem Schichtstapel,
- chemische und/oder mechanische Umwandelung der Seitenwände des Lochs oder der Löcher (3) im ersten dielektrischen Material (1) in ein dielektrisches Material (4) das durch die erste Ätzzusammensetzung ätzbar ist,
- auftragen eines elektrisch leitenden Materials (6) im Loch oder in den Löchern ,
- entfernen der Hartmaske und jedes Überschusses des leitfähigen Materials (6) um das umgewandelte dielektrische Material (4) freizulegen,
- zusammenbringen von der ersten Ätzzusammensetzung mit dem umgewandelten dielektrischen Material (4), um Letzteres zu entfernen.

4. Verfahren zur Herstellung von Luftspälten (7) nach einem der Ansprüche 1 bis 3, wobei die erste Ätzzusammensetzung Fluorwasserstoffsäure (HF) enthält.

5. Verfahren zur Herstellung von Luftspälten (7) nach einem der Ansprüche 1 bis 4, wobei der Schritt des Ätzens mindestens eines Lochs (3) durch ein oxidierendes Plasma durchgeführt wird.

6. Verfahren zur Herstellung von Luftspälten (7) nach Anspruch 5, wobei das oxidierende Plasma Sauerstoff enthält.

7. Verfahren zur Herstellung von Luftspälten (7) nach einem der Ansprüche 1 bis 4, wobei der Schritt des Ätzens mindestens eines Lochs (3) durch ein N₂/H₂ enthaltendes Plasma durchgeführt wird.

8. Verfahren zur Herstellung von Luftspälten (7) nach Anspruch 5 bis 7, wobei das Plasma außerdem eine Fluorkohlen(wasser)stoffverbindung enthält.

9. Verfahren zur Herstellung von Luftspälten (7) nach einem der Ansprüche 1 bis 8, wobei das erste dielektrische Material (1) ein SiCO:H Material ist.

10. Verfahren zur Herstellung von Luftspälten (7) nach einem der Ansprüche 1 bis 9, wobei das erste dielektrische Material (1) poröser ist als das zweite dielektrische Material (2).

11. Verfahren zur Herstellung von Luftspälten (7) nach einem der Ansprüche 1 bis 10, wobei das leitfähige Material (6) aus einer Gruppe gewählt wird die aus Metallen, Kohlenstoffnanoröhren und leitfähigen Polymeren besteht.

12. Verfahren zur Herstellung von Luftspälten (7) nach Anspruch 11, wobei das leitfähige Material (6) Kupfer ist.

13. Verfahren zur Herstellung von Luftspälten (7) nach einem der Ansprüche 1 bis 12, wobei der Schritt des Ätzens mindestens eines Lochs (3) im Schichtstapel und der Umwandlungsschritt gleichzeitig durchgeführt werden.

14. Verfahren zur Herstellung von Luftspälten (7) nach einem der Ansprüche 1 bis 12, wobei der Umwandlungsschritt in einer oxidierenden Umgebung durchgeführt wird.

15. Verfahren zur Herstellung von Luftspälten (7) nach Anspruch 14, wobei der Umwandlungsschritt eine UV/Ozon-Behandlung mit Zusatz eines Oxidationsmittels oder eine SCC02-Behandlung mit Zusatz eines Oxidationsmittels umfasst.

16. Verfahren zur Herstellung von Luftspälten (7) nach einem der Ansprüche 1 bis 15, wobei das dielektrische Material (4) Maße in einer Ebene kleiner als 1 µm, oder kleiner als 500 nm, oder kleiner als 100 nm, oder kleiner als 50 nm aufweist.

17. Verfahren zur Herstellung eines Halbleiterbauelements mit Luftspälten, ein Verfahren nach einem der Ansprüche 1 bis 16 umfassend.

18. Verfahren zur Herstellung eines Halbleiterbauelements mit Luftspälten nach Anspruch 17, außerdem den Schritt des Auftragens einer Sperrschicht (5), nach dem Umwandlungsschritt, umfassend.

19. Verfahren zur Herstellung eines Halbleiterbauelements mit Luftspälten nach Anspruch 17 oder 18, außerdem den Schritt des Auftragens einer Deckschicht auf dem Schichtstapel, nach dem Kontaktierungsschritt, umfassend.

20. Verfahren zur Herstellung eines Halbleiterbauelements mit Luftspälten nach Anspruch 19, wobei die Deckschicht eine SiC-Schicht ist.

## Revendications

1. Procédé pour réaliser des entrefers (7) dans une pile de couches d'un dispositif à semi-conducteurs, ladite pile de couches comprenant :
- un premier matériau diélectrique (1), qui est résistant à une première composition d'attaque,
- un deuxième matériau diélectrique (2) sur ledit premier matériau diélectrique (1),
dans lequel ledit procédé comprend les étapes consistant à :
- graver, avec une deuxième composition d'attaque, au moins un trou (3) dans ladite pile de couches,
- convertir chimiquement et/ou mécaniquement les parois latérales dudit ou desdits trous (3) dans ledit premier matériau diélectrique (1) en un matériau diélectrique (4) qui peut être gravé par ladite première composition d'attaque,
- déposer dans ledit ou lesdits trou(s) un matériau électriquement conducteur (6),
- retirer le deuxième matériau diélectrique (2) et toute surcharge dudit matériau conducteur (6) pour exposer le matériau diélectrique (4) converti,
- mettre ladite première composition d'attaque en contact avec ledit matériau diélectrique (4) converti pour retirer ce dernier.

2. Procédé pour réaliser des entrefers (7) selon la revendication 1, dans lequel ladite pile de couches comprend en outre un masque dur, tel qu'un masque dur en métal, sur ledit deuxième matériau diélectrique (2).

3. Procédé pour réaliser des entrefers (7) dans une pile de couches d'un dispositif à semi-conducteurs, ladite pile de couches comprenant :
- un premier matériau diélectrique (1), qui est résistant à une première composition d'attaque,
- un masque dur, tel qu'un masque dur en métal, sur ledit premier matériau diélectrique (1),
dans lequel ledit procédé comprend les étapes consistant à :
- graver, avec une deuxième composition d'attaque, au moins un trou (3) dans ladite pile de couches,
- convertir chimiquement et/ou mécaniquement les parois latérales dudit ou desdits trous (3) dans ledit premier matériau diélectrique (1) en un matériau diélectrique (4) qui peut être gravé par ladite première composition d'attaque,
- déposer dans ledit ou lesdits trou(s) un matériau électriquement conducteur (6),
- retirer le masque dur et toute surcharge dudit matériau conducteur (6) pour exposer le matériau diélectrique (4) converti,
- mettre ladite première composition d'attaque en contact avec ledit matériau diélectrique (4) converti pour retirer ce dernier.

4. Procédé pour réaliser des entrefers (7) selon l'une quelconque des revendications 1 à 3, dans lequel ladite première composition d'attaque comprend de l'acide fluorhydrique (HF).

5. Procédé pour réaliser des entrefers (7) selon l'une quelconque des revendications 1 à 4, dans lequel ladite étape d'attaque d'au moins un trou (3) est effectuée par un plasma oxydant.

6. Procédé pour réaliser des entrefers (7) selon la revendication 5, dans lequel ledit plasma oxydant comprend de l'oxygène.

7. Procédé pour réaliser des entrefers (7) selon l'une quelconque des revendications 1 à 4, dans lequel ladite étape d'attaque d'au moins un trou (3) est effectuée par un plasma comprenant du N₂/H₂.

8. Procédé pour réaliser des entrefers (7) selon les revendications 5 à 7, dans lequel ledit plasma comprend en outre un composé (hydro)fluorocarboné.

9. Procédé pour réaliser des entrefers (7) selon l'une quelconque des revendications 1 à 8, dans lequel ledit premier matériau diélectrique (1) est un matériau à base de SiCO:H.

10. Procédé pour réaliser des entrefers (7) selon l'une quelconque des revendications 1 à 9, dans lequel ledit premier matériau diélectrique (1) est plus poreux que ledit deuxième matériau diélectrique (2).

11. Procédé pour réaliser des entrefers (7) selon l'une quelconque des revendications 1 à 10, dans lequel ledit matériau conducteur (6) est sélectionné dans le groupe consistant en des métaux, des nanotubes de carbone et des polymères conducteurs.

12. Procédé pour réaliser des entrefers (7) selon la revendication 11, dans lequel ledit matériau conducteur (6) est du cuivre.

13. Procédé pour réaliser des entrefers (7) selon l'une quelconque des revendications 1 à 12, dans lequel l'étape d'attaque d'au moins un trou (3) dans ladite pile de couches et l'étape de conversion sont effectuées simultanément.

14. Procédé pour réaliser des entrefers (7) selon l'une quelconque des revendications 1 à 12, dans lequel l'étape de conversion est effectuée dans un environnement oxydant.

15. Procédé pour réaliser des entrefers (7) selon la revendication 14, dans lequel l'étape de conversion comprend un traitement aux UV/à l'ozone avec l'ajout d'un oxydant ou un traitement au SCCO2 avec l'ajout d'un oxydant.

16. Procédé pour réaliser des entrefers (7) selon l'une quelconque des revendications 1 à 15, dans lequel ledit matériau diélectrique (4) a des dimensions dans le plan inférieures à 1 µm, ou inférieures à 500 nm, ou inférieures à 100 nm, ou inférieures à 50 nm.

17. Procédé pour réaliser un dispositif à semi-conducteurs comportant des entrefers comprenant un procédé selon l'une quelconque des revendications 1 à 16.

18. Procédé pour réaliser un dispositif à semi-conducteurs comportant des entrefers selon la revendication 17, comprenant en outre l'étape consistant à déposer une barrière de charge d'espace (5), après ladite étape de conversion.

19. Procédé pour réaliser un dispositif à semi-conducteurs comportant des entrefers selon la revendication 17 ou 18, comprenant en outre l'étape consistant à déposer une couche de recouvrement sur ladite pile de couches, après ladite étape de mise en contact.

20. Procédé pour réaliser un dispositif à semi-conducteurs comportant des entrefers selon la revendication 19, dans lequel ladite couche de recouvrement est une couche de SiC.
